# EUROPÄISCHE PATENTSCHRIFT

(11) **EP 3 320 216 B1**
(45) Veröffentlichungstag und Bekanntmachung des Hinweises auf die Patenterteilung: **27.02.2019**
(21) Anmeldenummer: 16788077.2
(22) Anmeldetag: 26.10.2016
(51) Int. Cl.: F04D 27/00, G06F 17/50

(54) **SIMULATIONSVORRICHTUNG UND SIMULATIONSVERFAHREN**
SIMULATION DEVICE AND SIMULATION METHOD
DISPOSITIF DE SIMULATION ET PROCÉDÉ DE SIMULATION

(30) Priorität: 27.10.2015 DE 102015118289
(43) Veröffentlichungstag der Anmeldung: 16.05.2018
(73) Patentinhaber: EBM-Papst Mulfingen GmbH&CO. KG, 74673 Mulfingen (DE)
(72) Erfinder: SIGLOCH, Uwe, 74626 Bretzfeld (DE); LEMKE, Daniel, 74238 Krautheim-Klepsau (DE)
(74) Vertreter: Staeger & Sperling Partnerschaftsgesellschaft mbB
(86) Internationale Anmeldenummer: PCT/EP2016/075752
(87) Internationale Veröffentlichungsnummer: WO 2017/072154

(56) Entgegenhaltungen:
- US-A1- 2006 225 481
- US-A1- 2014 188 425

## Beschreibung

Die Erfindung betrifft einerseits eine Simulationsvorrichtung sowie ein Verfahren zur dynamischen energieoptimierten und betriebsbereichsoptimierten Selektion einer oder mehrere elektrisch betriebenen Strömungsmaschinen oder elektrisch betriebenen Aggregate für eine spezifische Anlagenkonfiguration oder Kühl-oder Lüftungsaufgabe unter Berücksichtigung zu erwartender sich dynamisch ändernder Betriebsbedingungen und unter Einbeziehung von Teilsystemausfällen. Ferner betrifft die Erfindung die Errichtung von Anlagen und Systemen zur Lüftung und/oder Kühlung unter Verwendung des erfindungsgemäßen Simulationsverfahrens.

Bei bisher bekannten computerunterstützten Selektionsverfahren (siehe z.B. die US 2014/0188425 A1) findet lediglich eine Auswahl von elektrisch betriebenen Geräten, wie z.B. Strömungsmaschinen, Ventilatoren oder Kühlaggregaten statt, bei der der Nutzer mit Hilfe von Suchfunktionen einen Produktbestand gezielt nach einzelnen Produkteigenschaften durchsuchen. Hierzu werden die Produkte anhand von technischen Eigenschaften klassifiziert. Zudem werden Datensätze zu den einzelnen Produkten angelegt.

Mit Hilfe anderer bekannter Verfahren lässt sich eine Selektion nach Eigenschaften von Produkten im Einsatz, d.h. im Betrieb nicht realisieren. So wird mit dem aus der US 5,717,865 A bekannten Verfahren zur Selektion lediglich mittels Auswahlmöglichkeiten und deren subjektiver Gewichtung eine Liste von Auswahlmöglichkeiten bereitgestellt, welche anhand eines dynamisch generierten Zuverlässigkeitswertes sortiert werden. Der Benutzer wird durch das Verfahren zwar in seiner Auswahl unterstützt, da eine Bewertung seiner Auswahl vorgenommen wird, jedoch sind seine Auswahlmöglichkeiten nicht durch applikationsspezifische Produkteigenschaften eingrenzbar. Es fehlt insofern die Möglichkeit einer sowohl statischen als auch dynamischen anlagenspezifischen Konfiguration von Strömungsmaschinen oder Aggregaten, insbesondere unter Berücksichtigung zu erwartender sich dynamisch ändernder Betriebsbedingungen und unter Einbeziehung von Teilsystemausfällen.

Gemäß der bekannten Selektionsverfahren lässt sich nur mit Hilfe von diversen Suchalgorithmen nach vom Benutzer eingegebenen konkreten Vorgaben suchen. Bei einer solchen Auswahl kommt es regelmäßig vor, dass entweder eine sehr große Anzahl von ähnlichen Produkten den vom Benutzer eingegeben technischen Vorgaben entspricht, wodurch dem Benutzer eine Auswahl erheblich erschwert wird oder es werden energetisch nicht optimale Produkte für Applikationen ermittelt, da nur statische Annahmen von Betriebsbedingungen verwendet werden. Dies liegt unter anderem an dem Umstand, dass die bisherigen Lösungen keine technische Möglichkeit bieten, Produkte aus dem Produktbestand zu ermitteln, welche unter energetischen Gesichtspunkten für ein konkretes dynamisches Applikationsumfeld optimierte und daher bevorzugte Produkte sind und wie diese in Wechselwirkung energieoptimiert zusammen arbeiten können.

Ein weiterer Nachteil bekannter Verfahren liegt darin, dass grundsätzlich keine applikationsspezifischen oder benutzerspezifischen Daten bei der Datenverarbeitung im Selektionsalgorithmus bei einer Analgensimulation einfließen können, da es bereits an einer entsprechenden Eingabefunktion und folglich Verarbeitungsfunktion mangelt.

In der Regel erfolgt eine Produktselektion in einem kaskadenartigen Auswahlverfahren, bei dem in einem Auswahlschritt ein Selektionsmodul eine Selektion eines bestimmten technischen Parameters vornimmt. So erfolgt aktuell zum Beispiel die Auswahl eines passenden Ventilators anhand des maximalen Betriebspunktes, welcher vom Ventilator in dessen geplanten Betrieb erreicht werden muss. So wird in einem für den Energieverbrauch relevanten Selektionsschritt die Fokussierung auf den Maximalbetriebspunkt gelenkt. Der Maximalbetriebspunkt eines Ventilators ist derjenige Betriebspunkt in einem möglichen Arbeitsraum des Ventilators, den ein bestimmter Ventilator erreichen muss.

Aktuell besteht ein zunehmendes Bedürfnis nach energiesparenden Strömungsmaschinen und demnach ein Bedürfnis zur Optimierung des gesamten Wirkungsgrades einer Anlage. So sollen z. B. moderne EC-Motoren, die beim Antrieb von Strömungsmaschinen zunehmend eingesetzt werden, die zukünftigen Forderungen an den Mindestmotorwirkungsgrad nach dem internationalen Standard IEC/TS 60034-30 erfüllen. Faktoren, die neben dem Motorwirkungsgrad den Energiebedarf einer über Strömungsmaschinen betriebenen lufttechnischen Anlage beeinflussen, sind unter anderem die geforderte Luftmenge, der Druckverlust der lufttechnischen Komponenten wie z.B. Auslässe, Luftverteilnetz, Klimakastengerät mit seinen Komponenten wie Filter, Wärmetauscher, usw. und der eingesetzte Ventilator als solcher.

Ferner ist zu berücksichtigen, dass die Leistungsaufnahme eines Ventilators abhängig vom Volumenstrom und oder der Druckerhöhung ist und die Effizienz abhängig davon, in welchem Lastbereich der Ventilator tatsächlich und insbesondere über welche Zeitspannen in der Applikation betrieben wird. So ist die Energieeffizienz unabhängig vom Maximalbetriebspunkt im Teillastbetrieb bei Drehstrom betriebenen Ventilatoren sehr niedrig und selbst bei EC-betriebenen Ventilatoren nur im Bereich von ca. 70%.

Ein Ventilator, der in einem Gerät oder in einer lufttechnischen Anlage eingebaut ist, muss gegen einen Strömungswiderstand arbeiten. Der Ventilator erzeugt dazu einen Überdruck (Druckerhöhung). Die Ventilatorkennlinie stellt diese gegenseitige Abhängigkeit von Volumenstrom und Druckerhöhung dar. Der Teillastbetrieb eines Ventilators wird entlang seiner Anlagenkennlinie ermittelt, wobei die Lage der Anlagenkennlinie im Ventilatorkennfeld durch den Maximalbetriebspunkt festgelegt wird. Die Anlagenkennlinie ist im Normalfall eine Parabel zweiter Ordnung.

Derzeit erfolgt die Auswahl eines Ventilators für eine lufttechnische Applikation über die Leistungsaufnahme im gewünschten Betriebspunkt im Schnittpunkt der Anlagenkennlinie. Im realen Betrieb stellen sich aber meist andere Betriebszustände ein, die sich abseits der Anlagenkennlinie befinden. Solche sich dynamisch veränderlichen Situationen können demnach derzeit weder bei einer manuellen Auswahl noch bei einer computerunterstützten Auswahl und noch weniger in der Wechselwirkung berücksichtigt werden, so dass ein energieoptimierter Betrieb häufig nur mittels der Optimierung von Parametern der Gruppe der beteiligten Aggregate erfolgen kann. Nicht gewährleistet ist, dass die Auswahl der Aggregate zur Implementierung eines Anlagenkonzeptes die dynamsichen Betriebszustände auch in einem zeitlich gewichteten Betriebsmodus erfassen und demnach eine Optimierung über die grundsätzliche statische Optimierung hinaus geht.

Demnach stehen derzeit keine geeigneten Auswahlverfahren und Anlagenerrichtungskonzepte zur Verfügung, welche eine energieoptimierte Selektion eines oder mehrerer Ventilatoren für eine lufttechnische Applikation und deren Implementierung in ein Anlagenkonzept ermöglichen.

Es ist daher Aufgabe der vorliegenden Erfindung, vorbesagte Nachteile zu überwinden und eine Einrichtung sowie ein computerunterstütztes Selektionsverfahren bereitzustellen, um eine dynamsiche energieoptimierte und/oder applikationsspezifische Selektion von Strömungsmaschinen, insbesondere von Ventilatoren und deren Implementierung für lufttechnische Anlagen auf einfache und bequeme Weise vornehmen zu können, wobei auch dynamisch von außen einwirkende Anlageneingriffe erfolgen sowie Anlagenausfälle bzw. Teilausfälle einzelner Aggregate berücksichtigt werden.

Unter den dynamisch von außen einwirkende Anlageneingriffen sind insbesondere solche Eingriffe zu verstehen, dass z. B. eine oder mehrere Beladungsvorgänge eines zu kühlenden Mediums in das System erfolgt, so dass für eine bestimmte Zeit ein von der bisherigen Lastsituation und den Betriebspunkten abweichende Leistungsaufnahme erforderlich ist, um die Kühlaufgabe zu erfüllen. Gleichermaßen gilt dies für reine lufttechnische Anlagenkonzepte.
Als Teilausfall wird ein solcher Zustand betrachtet, bei dem z. B. von n Strömungsmaschinen im System nur n-1 Strömungsmaschinen aktiv arbeiten, wärend die eine weitere Strömungsmaschine z. B. ausgefallen ist.

Die zuvor genannte Aufgabe wird durch eine Simulationsvorrichtung mit den Merkmalen nach Anspruch 1 gelöst.

Erfindungsgemäß wird demnach ein Simulationsvorrichtung vorgeschlagen, das ausgebildet ist, zur Ermittlung und Selektion einer Strömungsmaschine oder einer Gruppe von Strömungsmaschinen (z.B. Ventilatoren) mit sich dynamsich ändernden Betriebszuständen für eine lufttechnische Anlage, die in wenigstens einer erfassbaren Betriebsgröße einen betreffend dieser Betriebsgröße optimierten Wert, ausgewählt aus einer Anzahl von Strömungsmaschinen, besitzen. Als Betriebsgröße, betreffend der eine optimierte Selektion vorgenommen werden soll, ist insbesondere der Energieverbrauch oder ein Geräuschverhalten oder eine andere von den Betriebspunkten des oder der Strömungsmaschinen abhängige Betriebsgröße. Insofern erfolgt erfindungsgemäß eine Selektion durch Berücksichtigung mehrerer sich dynamsich ändernder Betriebspunkte und der entsprechenden Betriebsgröße an diesen Betriebspunkten. Insbesondere soll auch der Ausfall einer oder mehrere der Strömungsmaschinen berücksichtigt werden.

Besonders vorteilhaft ist es, wenn die mehreren Betriebspunkte als gewichtete, vorzugsweise zeitlich gewichtete Parameter in den Selektionsprozess einfließen.

Erfindungsgemäß ist die Simulationsvorrichtung folgendermaßen ausgebildet, nämlich mit:
a. einer Anzeigevorrichtung und einer Eingabevorrichtung zum Eingeben von Parametern, vorzugsweise von betriebsbezogenen Parametern und/oder strömungsmaschinenbezogenen Parametern;
b. einem Datenspeicher, in dem eine Vielzahl von betriebsspezifischen und/oder strömungsmaschinenspezifischen Leistungsdaten für eine Anzahl von Strömungsmaschinen abgespeichert ist,
c. einem Anlagensimulationsmodul AS mit veränderlich einstellbaren Parametern, welche dynamisch veränderliche Systemzustände über eine Zeitspanne T einer Anlage repräsentieren, wobei die Parameter Betriebsparameter und/oder dynamisch veränderliche Anlagenparameter und/oder einer Anzahl n' an aktiven Strömungsmaschinen (V1,..., Vn) ausgewählt aus n Strömungsmaschinen (V1,..., Vn) einer Anlage entsprechen,
d. einem Auswahloperator, der eine bestimmte Strömungsmaschine oder eine Gruppe bestimmter Strömungsmaschinen (V1,..., Vn) ausgewählt aus den vorhandenen Strömungsmaschinen, die im Datenspeicher (20) hinterlegt sind, gemäß einem Selektionsalgorithmus unter Berücksichtigung dynamischer, insbesondere zeitlich gewichteter Betriebszustände im Zeitintervall T auswählt, und
e. die Auswahl an der Anzeigevorrichtung anzeigt.

Weiter von Vorteil ist es, wenn der Auswahloperator bei der Auswahl einer Gruppe von n Strömungsmaschinen mit dem wenigstens einen erforderlichen Betriebsparameter, auch den Betriebszustand berücksichtigt, bei dem eine Anzahl n' der n Strömungsmaschinen nicht aktiv sind oder eine Störung aufweisen.

Weiter vorteilhaft kann vorgesehen sein, dass der Auswahloperator bei der Auswahl einer Gruppe von n Strömungsmaschinen auch den Betriebszustand berücksichtigt, bei dem die Anzahl n' an Strömungsmaschinen rückwärts entgegen der bestimmungsgemäßen Strömungsrichtung der betroffenen n' Strömungsmaschinen (V1,..., Vn) durchströmt werden. Dies kann in besonderer Weise dadurch umgesetzt werden, dass ferner eine Software zum Steuern des Betriebszustandes vorgesehen ist.

Weiter vorteilhaft ist es, wenn die Simulationsvorrichtung ferner einen Berechnungsoperator aufweist, der aus den vom Nutzer eingegebenen Parametern einen zu der zu optimierenden Betriebsgröße (z.B. niedriger Energieverbrauch) korrespondierenden Selektionswert ermittelt, der im oben genannten Schritt c) bei der Auswahl verwendet wird. So kann der Benutzer z.B. als Parameter mehrere Betriebspunkte (z.B. unterschiedliche Teillastbetriebspunkte und einen Maximalbetriebspunkt) auswählen. Zu den jeweiligen Betriebspunkten ist im Datenspeicher mit Vorteil z.B. ein Energieverbrauchswert hinterlegt. So kann als weiterer zu den zuvor eingegebenen betriebsbezogenen Parametern ein zusätzlicher, mit diesen Parametern korrelierter betriebsbezogener Parameter eingegeben werden, der bei der Selektion in den Auswertealgorithmus einfließt. So kann z.B. eine Zeitspanne, in der die Strömungsmaschine an einem der Betriebspunkte betrieben wird, als weiterer Parameter eingegeben werden.

Besonders vorteilhaft ist es, wenn ferner eine Bilderzeugungseinheit vorgesehen ist, welche die eingegebenen betriebsbezogenen Parameter und/oder strömungsmaschinenbezogenen Parameter als grafische Ansichten und/oder Symbole, vorzugsweise unterschiedlicher Größe, weiter vorzugsweise als Kreise mit unterschiedlichem Durchmesser auf der Anzeigeeinheit darstellt.

Es ist erfindungsgemäß weiter mit Vorteil vorgesehen, wenn die abgespeicherten Leistungsdaten für unterschiedliche Betriebspunkte und/oder Betriebszustände der Strömungsmaschinen abgespeichert sind. Bevorzugt ist es, wenn die Leistungsdaten kontinuierlich entlang bestimmter Parameter hinterlegt sind. So können z.B. die Ventilatorkennlinien bzw. das Ventilatorkennlinienfeld hinterlegt sein.

In einer vorteilhaften Ausgestaltung der Erfindung ist vorgesehen, dass die Simulationsvorrichtung ferner ein Datenfeld zum Abspeichern oder Eingeben eines Sollwertes einer bestimmten Betriebsgröße aufweist und dieser Sollwert als ein oberer oder unterer Grenzwert verwendet wird. So kann z.B. bei der Selektion eines Ventilators oder einer Gruppe von Ventilatoren zum Betreiben einer lufttechnischen Anlage als Sollwert ein maximaler Gesamtenergieverbrauch definiert werden, den die Anlage im Jahr nicht überschreiten darf und der demnach bei der Selektion einen Grenzwert darstellt. Die erfindungsgemäße Selektion wird nur solche Ventilatoren ermitteln, deren energetische Leistungsdaten über die Zeitspanne, die als Parameter eingegeben wurden, zu einem Gesamtenergieverbrauch führt, der unterhalb des zuvor definierten Grenzwertes liegt, wobei gleichzeitig die unterschiedlichen Betriebszustände (Betriebspunkte) berücksichtigt sind.

Weiter vorteilhaft ist es daher, wenn ferner ein Energieermittlungsoperator vorgesehen ist, welcher bei einer Eingabe von betriebsbezogenen Parametern einen konkreten Energiebetrag oder einen einem prognostizierten Energieverbrauch dazu äquivalenten Wert aus den Leistungsdaten und den betriebsbezogenen Parametern (z.B. Zeitspanne, Betriebspunkte) für die ausgewählten Strömungsmaschinen ermittelt und an der Anzeigevorrichtung anzeigt.
Weiter von Vorteil ist eine Ausgestaltung der Simulationsvorrichtung bei dem das Simulationsvorrichtung eine Steuerungssoftware aufweist, um den Betriebszustand einer Strömungsmaschine oder einer ausgewählten Gruppe von n Strömungsmaschinen einzustellen oder anzupassen.

Besonders vorteilhaft ist eine Ausführungsform, bei der die Steuerungssoftware ausgebildet ist einen gewünschten Betriebszustand der oder der ausgewählten Gruppe von n Strömungsmaschinen unter Berücksichtigung von Störzuständen einer oder mehrerer der Strömungsmaschinen einzustellen, zu erhalten oder anzupassen.

In einer weiteren vorteilhaften Ausführungsform der Erfindung ist die Steuerungssoftware so ausgebildet, dass eine Rückströmung in den n' nicht aktiven oder gestörten Strömungsmaschinen durch Aktivieren einer Leistungserhöhung der n-n' weiteren Strömungsmaschinen kompensiert wird. Hierzu kann auch vorgesehen sein, dass eine Betriebsinformation z. B. zur Leistungsanpassung bereits bei der Auswahl der Strömungsmaschinen durch den Auswahloperator generiert wird.

Vorteilhaft ist dabei, dass die exakte energetische Erfassung der Betriebszustände der Strömungsmaschinen beim Betrieb erfolgen kann, z. B. alle Strömungsmaschinen in Betrieb, eine Störung, mehrere Störungen,...). Es ist daher weiter von Vorteil, wenn die Strömungsdaten in den n' gestörten Strömungsmaschinen, in denen eine Rückströmung auftritt, mittels einer Erfassungseinheit gemessen werden, um diese an die Steuerungssoftware zur Anpassung oder Einstellung des Betriebszustandes zu übertragen.

Hierdurch wird ein Redundanzbetrieb auch ohne wirksame Rückströmklappen gewährleistet, was eine insgesamt hohe Prozesssicherheit bei diversen Betriebssituationen und Störungen gewährleistet.

Besonders vorteilhaft ist es daher, wenn die Simulationsvorrichtung bei der Auswahl einer Strömungsmaschine oder einer Gruppe von n Strömungsmaschinen bereits wenigstens eine Inbetriebnahmeinformation und/oder Steuerungsinformation für die Inbetriebnahme und/oder den Betrieb bzw. die Steuerung des Betriebes der Strömungsmaschine oder der Gruppe von Strömungsmaschinen (V1,..., Vn) generiert und vorzugsweise über eine drahtgebundene oder drahtlose Datenschnittstelle bereitstellt.

Die Ausgabe oder Weitergabe der generierten Inbetriebnahmeinformation und/oder Steuerungsinformation kann mittels herkömmlicher Übertragungstechniken erfolgen, wie mittels Datenträger, drahtlose Datenübertragung, maschinenlesbarer Ausdruck usw.

Weiter von Vorteil ist es, wenn Simulationsvorrichtung dadurch gekennzeichnet ist, dass die zu simulierende Anlage als eine Visualisierung an einem Display oder einer Ausgabeeinrichtung angezeigt und/oder ausgegeben wird und bei Änderung der sich ändernden einstellbaren Parametern, welche dynamisch veränderliche Systemzustände über eine Zeitspanne T einer Anlage repräsentieren, die jeweils selektierten Strömungsmaschinen (V1,..., Vn) in der simulierten Anlage dargestellt werden.

Die Simulationsvorrichtung gemäß der Erfindung erlaubt ein Selektionsverfahren zur Ermittlung einer Strömungsmaschine oder einer Gruppe von Strömungsmaschinen für eine lufttechnische Anlage, die in wenigstens einer Betriebsgröße einen betreffend dieser Betriebsgröße optimierten Betriebszustand, ausgewählt aus einer Anzahl von Strömungsmaschinen, besitzen, vorzugsweise unter Verwendung einer wie zuvor beschriebenen Simulationsvorrichtung mit den folgenden Schritten:
a) Eingeben von wenigstens einem betriebsbezogenen Parameter und/oder strömungsmaschinenbezogenen Parameter mittels der Eingabevorrichtung,
b) Ermitteln einer Strömungsmaschine oder einer Gruppe von Strömungsmaschinen in Abhängigkeit der eingegebenen Parameter vorzugsweise nach Betätigen eines Eingabeelements, wobei mittels einem Anlagensimulationsmodul AS veränderlich einstellbare Parametern eingegeben werden, welche dynamisch veränderliche Systemzustände über eine Zeitspanne T einer Anlage repräsentieren, wobei die Parameter Betriebsparameter und/oder dynamisch veränderliche Anlagenparameter und/oder einer Anzahl n' an aktiven Strömungsmaschinen (V1,..., Vn) ausgewählt aus n Strömungsmaschinen (V1,..., Vn) einer Anlage entsprechen,
c) Darstellen der Strömungsmaschine oder der Gruppe von ermittelten Strömungsmaschinen auf der Anzeigeeinheit.

Besonders bevorzugt ist es, wenn wenigstens zwei vorzugsweise mehrere Betriebspunkte als betriebsbezogene Parameter verwendet werden und wenn ferner eine Zeitspanne für die Betriebsdauer in Verbindung mit den eingegebenen Betriebspunkten definiert wird, so dass eine Gewichtung der relevanten Betriebsparameter erfolgt.

Es können ferner auch andere oder weitere betriebsbezogene Parameter eingegeben werden, die bei dem Auswahlalgorithmus einfließen, so z.B. die Luftdichte am geplanten Einbauort oder die Größe des geplanten Einbauraumes ( z.B. die Breite und Höhe).

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt.

Es zeigen:
- Fig. 1: Schematische Darstellung einer erfindungsgemäßen Simulationsvorrichtung;
- Fig. 2: ein Ventilatorkennfeld, auf dem diverse Betriebspunkte dargestellt sind;
- Fig. 3: Ablaufdiagramm gemäß einem Ausführungsbeispiel;
- Fig. 4: Ablaufdiagramm gemäß einem alternativen Ausführungsbeispiel.

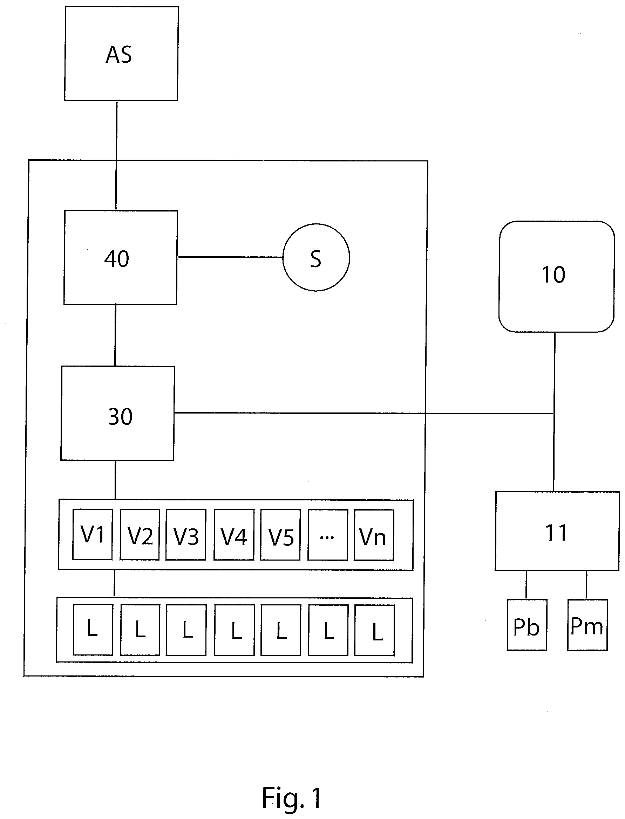

Im Folgenden wird die Erfindung anhand von Ausführungsbeispielen mit Bezug auf die Figuren 1 bis 5 näher beschrieben, wobei gleiche Bezugszeichen auf gleiche strukturelle und/oder funktionale Merkmale hinweisen.

Die Figur 1 zeigt eine schematische Darstellung einer erfindungsgemäßen Simulationsvorrichtung. Das Simulationsvorrichtung ist bestimmungsgemäß ausgebildet zur Ermittlung und Selektion eines oder einer Gruppe von Strömungsmaschinen V1,..., Vn für eine lufttechnische Anlage, die in wenigstens einer erfassbaren Betriebsgröße einen betreffend dieser Betriebsgröße optimierten Wert, ausgewählt aus einer Anzahl von Strömungsmaschinen V1,..., Vn, besitzen. Die Simulationsvorrichtung 1 ist mit einer Anzeigevorrichtung 10 und einer Eingabevorrichtung 11 zum Eingeben von Parametern, vorzugsweise von betriebsbezogenen Parametern Pb und/oder strömungsmaschinenbezogenen Parametern Pm ausgebildet sowie einem Datenspeicher 20, in dem eine Vielzahl von betriebsspezifischen und/oder strömungsmaschinenspezifischen Leistungsdaten L für eine Anzahl von Strömungsmaschinen (V1,..., Vn) abgespeichert ist. Ferner ist die Simulationsvorrichtung mit einem Anlagensimulationsmodul AS verbunden bzw. ausgebildet.

Ferner ist ein Auswahloperator 30 vorgesehen, der aus den in dem Datenspeicher 20 der Simulationsvorrichtung gespeicherten strömungsmaschinenbezogenen Daten, abhängig von den eingegebenen Parametern Pb, Pn, eine oder eine Gruppe von Strömungsmaschinen V1,..., Vn gemäß einem Selektionsalgorithmus auswählt, und die Auswahl an der Anzeigevorrichtung 10 anzeigt.

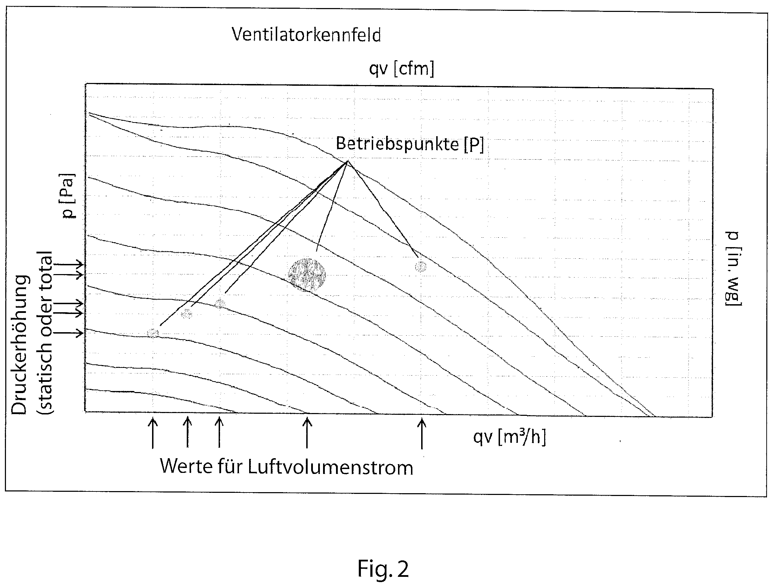

In der Simulationsvorrichtung ist ferner ein Berechnungsoperator 40 vorgesehen, der aus den Parametern Pb, Pm einen zu der zu optimierenden Betriebsgröße korrespondierenden Selektionswert S ermittelt, mit dem die Selektion aus der Reihe der Strömungsmaschinen V1,..., Vn vorgenommen wird. Dabei korrelieren die abgespeicherten Leistungsdaten L mit den unterschiedlichen Betriebspunkten P, wie diese in der Figur 2 beispielhaft auf einem Ventilatorkennfeld gezeigt sind. Das Ventilatorkennfeld zeigt die Kennlinien in Abhängigkeit vom Druck und dem Luftvolumenstrom. Die unterschiedlichen Betriebspunkte P sind durch einen entsprechenden Kreis als Symbol an diesem Betriebspunkt dargestellt, wobei der Durchmesser repräsentativ für die Zeitspanne an diesem Betriebspunkt ist. Je größer der Zeitraum, über den ein Ventilator an einem bestimmter Betriebspunkt betrieben wird, desto größer der dargestellte Durchmesser. Ein Betriebspunkt wird durch die Eingabe von Luftvolumenstrom und Druckerhöhung bestimmt.

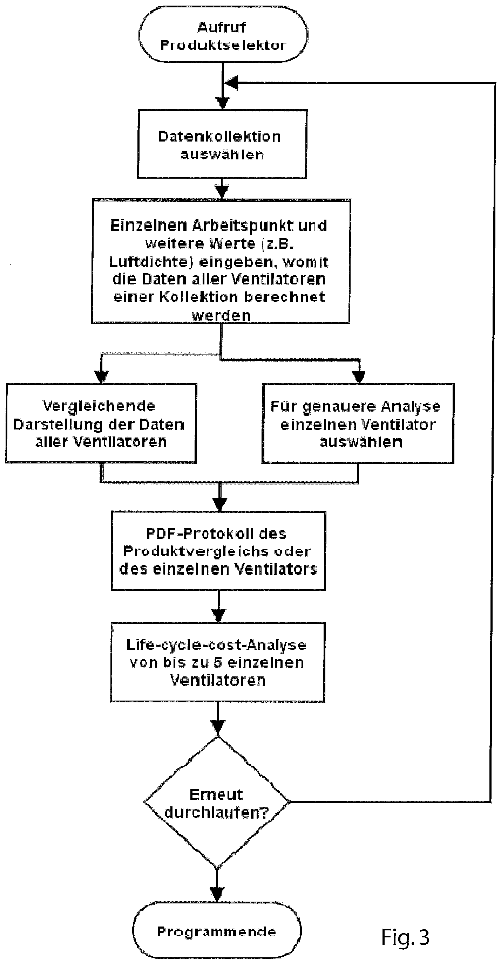

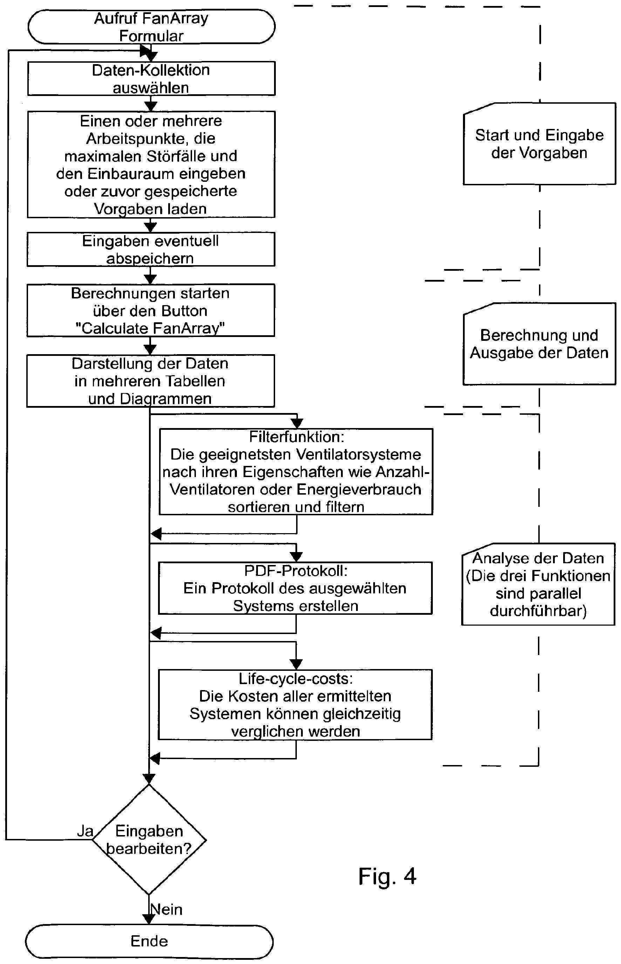

In den Figuren 3 und 4 sind schematische Ablaufdiagramme zu Ausführungsvarianten des erfindungsgemäßen Verfahrens gezeigt. Das Verfahren lässt sich in eine Start- und Eingabephase, eine Berechnungs- und Selektionsphase und ggf. in eine zusätzliche Auswertephase aufteilen.

Im vorliegenden Beispiel erfolgt zunächst der Aufruf der entsprechenden Datenverarbeitungsoftware. Danach erfolgt eine Auswahl der Datenkollektion, so dass anschließend entsprechende Werte und Parameter eingegeben werden können, wie z.B. die Luftdichte. Mit diesen Werten erfolgt der nächste Schritt der Berechnungs- und Selektionsphase, bei dem am Ende eine Darstellung des oder des selektierten Ventilators erfolgt. Danach kann in der Auswertephase ein Produktvergleich und die Analyse per Datei ausgegeben werden. Der Prozess kann ggf. mit geänderten Parametern erneut durchlaufen werden. Es besteht ferner die Möglichkeit, einzelne Ventilatoren manuell auszuwählen und danach die Analyse durchzuführen.

Wie in dem alternativen Ablaufdiagramm gezeigt, können die Eingabedaten auch in einem Zwischenspeicher gespeichert werden und ggf. eine Berechnung erst nach Drücken einer Eingabe oder Eingabeaufforderung "Calculate Fan Array" erfolgen.

Im vorliegenden Ausführungsbeispiel wird für einen Ventilator der Gesamtenergieverbrauch über einen einzustellenden Betriebszeitraum bestimmt. Der einzustellende Betriebszustand des Ventilators erfolgt durch die zuvor genannten Eingaben mehrerer Betriebspunkte P und deren Betriebsdauer über die Eingabevorrichtung 11, wodurch sich die Gesamtarbeitsstunden ergeben.

Durch die zusätzliche Eingabe von z.B. Energiekosten, Investitionskosten oder dergleichen lassen sich auch betriebswirtschaftliche Werte ermitteln und in der Analyse darstellen. So können z.B. auch CO2-Äquivalenzwerte ermittelt werden, um entsprechend den Carbon-Foodprint zu erhalten.

Die Erfindung beschränkt sich in ihrer Ausführung nicht auf die vorstehend angegebenen bevorzugten Ausführungsbeispiele. Vielmehr ist eine Anzahl von Varianten denkbar, welche von der dargestellten Lösung auch bei grundsätzlich anders gearteten Ausführungen Gebrauch macht, wobei der Gegenstand der Erfindung durch die folgenden Ansprüche definiert wird.

## Patentansprüche

1. Simulationsvorrichtung ausgebildet zur Ermittlung und Selektion einer Strömungsmaschine oder einer Gruppe von Strömungsmaschinen (V1,..., Vn), insbesondere Ventilatoren für eine lufttechnische Anlage mit sich dynamsich ändernden Betriebszuständen, die in wenigstens einer erfassbaren Betriebsgröße einen betreffend dieser Betriebsgröße optimierten Wert, ausgewählt aus einer Anzahl von n Strömungsmaschinen (V1,..., Vn) besitzt/besitzen, mit:
a. einer Anzeigevorrichtung (10) und einer Eingabevorrichtung (11) zum Eingeben von Parametern, insbesondere von betriebsbezogenen Parametern (Pb) und/oder strömungsmaschinenbezogenen Parametern (Pm);
b. einem Datenspeicher (20), in dem eine Vielzahl von betriebsspezifischen und/oder strömungsmaschinenspezifischen Leistungsdaten (L) für eine Anzahl von Strömungsmaschinen (V1,..., Vn) abgespeichert ist,
c. einem Anlagensimulationsmodul (AS) mit veränderlich einstellbaren Parametern, welche dynamisch veränderliche Systemzustände über eine Zeitspanne T einer Anlage repräsentieren, wobei die Parameter Betriebsparameter und/oder dynamisch veränderliche Anlagenparameter und/oder einer Anzahl n' an aktiven Strömungsmaschinen (V1,..., Vn) ausgewählt aus n Strömungsmaschinen (V1,..., Vn) einer Anlage entsprechen,
d. einem Auswahloperator (30), der aus den in dem Datenspeicher (20) gespeicherten strömungsmaschinenbezogenen Daten abhängig von den eingegebenen Parametern (Pb, Pn) eine bestimmte Strömungsmaschine oder eine Gruppe bestimmter Strömungsmaschinen (V1,..., Vn) ausgewählt aus den vorhandenen Strömungsmaschinen, die im Datenspeicher (20) hinterlegt sind, gemäß einem Selektionsalgorithmus unter Berücksichtigung dynamischer, insbesondere zeitlich gewichteter Betriebszustände im Zeitintervall T auswählt, und
e. die Auswahl an der Anzeigevorrichtung (10) anzeigt.

2. Simulationsvorrichtung nach Anspruch 1, **dadurch gekennzeichnet, dass** der Auswahloperator (30) bei der Auswahl einer Gruppe von n Strömungsmaschinen (V1,..., Vn) mit dem wenigstens einen erforderlichen Betriebsparameter, auch den Betriebszustand berücksichtigt, bei dem eine Anzahl n' der n Strömungsmaschinen (V1,..., Vn) nicht aktiv sind oder eine Störung aufweisen.

3. Simulationsvorrichtung nach Anspruch 2, **dadurch gekennzeichnet, dass** der Auswahloperator (30) bei der Auswahl einer Gruppe von n Strömungsmaschinen (V1,..., Vn) auch den Betriebszustand berücksichtigt, bei dem die Anzahl n' an Strömungsmaschinen (V1,..., Vn) rückwärts entgegen der bestimmungsgemäßen Strömungsrichtung der betroffenen n'an Strömungsmaschinen (V1,..., Vn) durchströmt werden.

4. Simulationsvorrichtung nach Anspruch 1, **dadurch gekennzeichnet, dass** die Simulationsvorrichtung (1) ferner einen Berechnungsoperator (40) aufweist, der aus den Parametern (Pb, Pm) einen zu der zu optimierenden Betriebsgröße korrespondierenden Selektionswert (S) ermittelt, der in Schritt d) bei der Auswahl verwendet wird.

5. Simulationsvorrichtung nach Anspruch 1 oder 2, **dadurch gekennzeichnet, dass** die abgespeicherten Leistungsdaten (L) für unterschiedliche Betriebspunkte (P) und/oder Betriebszustände der Strömungsmaschine/n (V1,..., Vn) abgespeichert sind.

6. Simulationsvorrichtung nach einem der vorhergehenden Ansprüche, **dadurch gekennzeichnet, dass** die Selektion in Schritt d) aus Anspruch 1 betreffend wenigstens dem Energieverbrauch, einem Geräuschverhalten oder einer anderen von den Betriebspunkten (P) des oder der Strömungsmaschine/n (V1,..., Vn) abhängigen Betriebsgröße erfolgt.

7. Simulationsvorrichtung nach einem der vorhergehenden Ansprüche, **dadurch gekennzeichnet, dass** die Simulationsvorrichtung ein Datenfeld zum Abspeichern oder Eingeben eines Sollwertes (S) einer Betriebsgröße aufweist und dieser Sollwert (S) als ein oberer oder unterer Grenzwert bei der Ermittlung des Selektionswertes (SW) verwendet wird.

8. Simulationsvorrichtung nach einem der vorhergehenden Ansprüche, **dadurch gekennzeichnet, dass** ferner ein Energieermittlungsoperator (50) vorgesehen ist, welcher bei einer Eingabe von betriebsbezogenen Parametern (Pb) einen Energiebetrag oder einen einem prognostizierten Energieverbrauch dazu äquivalenten Wert aus den Leistungsdaten (L) und den betriebsbezogenen Parametern (Pb) für die ausgewählte Strömungsmaschinen (V1,..., Vn) ermittelt und an der Anzeigevorrichtung (10) anzeigt.

9. Simulationsvorrichtung nach zumindest einem der vorhergehenden Ansprüche, **dadurch gekennzeichnet, dass** eine Bilderzeugungseinheit vorgesehen ist, welche die eingegebenen betriebsbezogenen Parameter (Pb) und/oder strömungsmaschinenbezogenen Parameter (Pm) als grafische Ansichten und/oder Symbole, insbesondere unterschiedlicher Größe, insbesondere als Kreise mit unterschiedlichem Durchmesser auf der Anzeigeeinheit (10) darstellt.

10. Simulationsvorrichtung nach einem der vorhergehenden Ansprüche, **dadurch gekennzeichnet, dass** als strömungsmaschinenspezifische Leistungsdaten (L) zumindest die Ventilatorkennlinien oder das Ventilatorkennlinienfeld verwendet wird, und bevorzugt auf der Anzeigeeinheit (10) darstellbar ist.

11. Simulationsvorrichtung nach einem der vorhergehenden Ansprüche, **dadurch gekennzeichnet, dass** das Simulationsvorrichtung eine Steuerungssoftware aufweist, um den Betriebszustand der oder der ausgewählten Gruppe von n Strömungsmaschinen (V1,..., Vn) einzustellen oder anzupassen.

12. Simulationsvorrichtung nach Anspruch 11, **dadurch gekennzeichnet, dass** die Steuerungssoftware ausgebildet ist einen gewünschten Betriebszustand der oder der ausgewählten Gruppe von n Strömungsmaschinen (V1,..., Vn) unter Berücksichtigung von Störzuständen einer oder mehrerer der Strömungsmaschinen (V1,..., Vn) einzustellen, zu erhalten oder anzupassen.

13. Simulationsvorrichtung nach Anspruch 11 oder 12, **dadurch gekennzeichnet, dass** die Steuerungssoftware ausgebildet ist eine Rückströmung in n' nicht aktiven oder gestörten Strömungsmaschinen (V1,..., Vn) durch Aktivieren einer Leistungserhöhung der n-n' weiteren Strömungsmaschinen (V1,..., Vn) zu kompensieren.

14. Simulationsvorrichtung nach Anspruch 13, **dadurch gekennzeichnet, dass** die Strömungsdaten in den n' Strömungsmaschinen mit einer Rückströmung mittels einer Erfassungseinheit gemessen werden, um diese an die Steuerungssoftware zur Anpassung oder Einstellung des Betriebszustandes zu übertragen.

15. Simulationsvorrichtung nach einem der vorhergehenden Ansprüche, **dadurch gekennzeichnet, dass** die Simulationsvorrichtung bei der Auswahl einer Strömungsmaschine oder einer Gruppe von n Strömungsmaschinen (V1,..., Vn) eine Inbetriebnahmeinformation und/oder Steuerungsinformation für die Inbetriebnahme und/oder den Betrieb der Strömungsmaschine oder der Gruppe von Strömungsmaschinen (V1,..., Vn) generiert und vorzugsweise über eine drahtgebundene oder drahtlose Datenschnittstelle bereitstellt.

16. Simulationsvorrichtung nach einem der vorhergehenden Ansprüche, **dadurch gekennzeichnet, dass** die Anlage als eine Visualisierung an einem Display oder einer Ausgabeeinrichtung ausgegeben wird und bei Änderung der die sich ändernden einstellbaren Parametern, welche dynamisch veränderliche Systemzustände über eine Zeitspanne T einer Anlage repräsentieren, die jeweils selektierten Strömungsmaschinen (V1,..., Vn) in der simulierten Anlage dargestellt werden.

## Claims

1. A simulation device designed to determine and select a turbomachine or a group of turbomachines (V1,..., Vn), in particular fans for a ventilation system with dynamically changing operating states, said device possessing, in at least one detectable operating variable, a value that is optimized with respect to this operating variable, chosen from a number of turbomachines (V1,..., Vn), with:
a. an indicator device (10) and an input device (11) for inputting parameters, in particular operation-related parameters (Pb) and/or turbomachine-related parameters (Pm);
b. a data storage device (20), in which a plurality of operation-specific and/or turbomachine-specific performance data (L) for a number of turbomachines (V1,..., Vn) are stored;
c. a system simulation module (AS) with adjustable parameters, which represent dynamically changing system states over a time span T of a system, wherein the parameters correspond to operating parameters and/or dynamically changeable system parameters and/or a number n' of active turbomachines (V1,..., Vn) chosen from n turbomachines (V1,..., Vn) of a system;
d. a choice operator (30), which chooses, based on the turbomachine-related data stored in the data storage device (20) and dependent on the inputted parameters (Pb, Pn), a specific turbomachine or a group of specific turbomachines (V1,..., Vn) chosen from the existing turbomachines stored in the data storage device (20), according to a selection algorithm and under consideration of dynamic, in particular time-weighted, operating states in the time interval T; and
e. which indicates the choice on the indicator device (10).

2. The simulation device according to Claim 1, **characterized in that** the choice operator (30), when choosing a group of n turbomachines (V1,.., Vn) with the at least one required operating parameter, also considers the operating state, in which a number n' of the n turbomachines (V1,..., Vn) are not active or exhibit an error.

3. The simulation device according to Claim 2, **characterized in that** the choice operator (30), when choosing a group of n turbomachines (V1,.., Vn), also considers the operating state, in which the flow through of the number n' of turbomachines (V1,..., Vn) is reversed compared to the intended direction of flow in the affected number n' of turbomachines (V1,..., Vn).

4. The simulation device according to Claim 1, **characterized in that** the simulation device (1) also includes a calculation operator (40), which from the parameters (Pb, Pm) determines a selection value (S) corresponding to the operating variable to be optimized, which is used for the choice in step d).

5. The simulation device according to Claim 1 or 2, **characterized in that** the stored performance data (L) are stored for various operating points (P) and/or operating states of the turbomachines (V1,..., Vn).

6. The simulation device according to one of the preceding claims, **characterized in that** the selection in step d) of Claim 1 is made in relation to at least the energy consumption, a noise characteristic or another operating variable dependent on the operating points (P) of the turbomachine(s) (V1,..., Vn).

7. The simulation device according to one of the preceding claims, **characterized in that** the simulation device includes a data field for storing or entering a target value (S) of an operating variable and that this target value (S) is used as an upper or lower limit when determining the selection value (SW).

8. The simulation device according to one of the preceding claims, **characterized in that** an energy determining operator (50) is provided, which upon entry of operation-related parameters (Pb) determines an energy value or an equivalent value based on a forecast energy consumption from the performance data (L) and the operation-related parameters (Pb) for the selected turbomachines (V1,..., Vn) and which indicates the same on the indicator device (10).

9. The simulation device according to at least one of the preceding claims, **characterized in that** an image generation unit is provided, which represents the entered operation-related parameters (Pb) and/or turbomachine-related parameters (Pm) as graphic visualizations and/or symbols, in particular of various sizes, in particular as circles with various diameters, on the indicator unit (10).

10. The simulation device according to one of the preceding claims, **characterized in that** at least the fan characteristics or fan characteristics diagram are/is used as turbomachine-specific performance data (L), and that the same preferably can be displayed on the indicator unit (10).

11. The simulation device according to one of the preceding claims, **characterized in that** the simulation device includes a control software to adjust or modify the operating state of the turbomachines (V1,..., Vn) or of the chosen group of said turbomachines.

12. The simulation device according to Claim 11, **characterized in that** the control software is designed to adjust, maintain or adapt a desired operating state of the turbomachines (V1,..., Vn) or of the chosen group of said turbomachines under consideration of fault states of one or more of the turbomachines (V1,..., Vn).

13. The simulation device according to Claim 11 or 12, **characterized in that** the control software is designed to compensate for a back flow in n' non-active or faulty turbomachines (V1,..., Vn) by activating an increase in performance of the n-n' other turbomachines (V1,..., Vn).

14. The simulation device according to Claim 13, **characterized in that** the flow data in the n' turbomachines with a backflow are measured via a capturing unit to transmit said flow data to the control software for adapting or adjusting the operating state.

15. The simulation device according to one of the preceding claims, **characterized in that** the simulation device, when choosing a turbomachine or a group of n turbomachines (V1,..., Vn), generates start-up information and/or control information for the start-up and/or the operation of the turbomachine or the group of turbomachines (V1,..., Vn) and that the simulation device preferably makes this information available via a wired or wireless data interface.

16. The simulation device according to one of the preceding claims, **characterized in that** the system is shown as a visualization on a display or output device, and that the respective, selected turbomachines (V1,..., Vn) are indicated in the simulated system in case of a change of the adjustable parameters, which represent dynamically changeable system states over a time span T of a system.

## Revendications

1. Dispositif de simulation réalisé pour la détermination et la sélection d'une turbomachine ou d'un groupe de turbomachines (V1, ..., Vn), en particulier des ventilateurs pour une installation aéraulique avec des états de fonctionnement à changement dynamique, qui dispose/disposent dans au moins une grandeur détectable, une valeur optimisée concernant cette grandeur, sélectionnée parmi un nombre de n turbomachines (V1, ..., Vn), avec :
a. un dispositif d'affichage (10) et un dispositif de saisie (11) pour la saisie de paramètres, en particulier de paramètres liés au fonctionnement (Pb) et/ou de paramètres liés à la turbomachine (Pm) ;
b. une mémoire de données (20), dans laquelle une pluralité de données de performance (L) spécifiques au fonctionnement et/ou spécifiques à la turbomachine est enregistrée pour un nombre de turbomachines (V1, ..., Vn),
c. un module de simulation d'installation (AS) avec des paramètres à réglage variable, lesquels représentent des états de système à changement dynamique sur une période de temps T d'une installation, dans lequel les paramètres correspondent à des paramètres de fonctionnement et/ou à des paramètres d'installation à changement dynamique et/ou à un nombre n' de turbomachines (V1, ..., Vn) actives sélectionné parmi n turbomachines (V1, ..., Vn) d'une installation,
d. un opérateur de sélection (30), qui sélectionne parmi les données liées à la turbomachine enregistrées dans la mémoire de données (20) en fonction des paramètres saisis (Pb, Pn), une turbomachine déterminée ou un groupe de turbomachines déterminées (V1, ...., Vn) sélectionnées parmi les turbomachines présentes, qui sont déposées dans la mémoire de données (20), conformément à un algorithme de sélection en tenant compte d'états de fonctionnement dynamiques, en particulier à pondération temporelle dans l'intervalle de temps T, et
e. affiche la sélection sur le dispositif d'affichage (10).

2. Dispositif de simulation selon la revendication 1, **caractérisé en ce que** l'opérateur de sélection (30) lors de la sélection d'un groupe de n turbomachines (V1, ..., Vn) avec l'au moins un paramètre de fonctionnement nécessaire, tient aussi compte de l'état de fonctionnement, dans lequel un nombre n' des n turbomachines (V1, ..., Vn) ne sont pas actives ou présentent un dérangement.

3. Dispositif de simulation selon la revendication 2, **caractérisé en ce que** l'opérateur de sélection (30) lors de la sélection d'un groupe de n turbomachines (V1, ..., Vn) tient aussi compte de l'état de fonctionnement, dans lequel le nombre n' de turbomachines (V1, ..., Vn) est traversé vers l'arrière dans le sens contraire à la direction d'écoulement conformément à l'utilisation des n' turbomachines (V1, ..., Vn) concernées.

4. Dispositif de simulation selon la revendication 1, **caractérisé en ce que** le dispositif de simulation (1) présente en outre un opérateur de calcul (40), qui détermine à partir des paramètres (Pb, Pm) une valeur de sélection (S) correspondant à la grandeur à optimiser, qui est utilisée dans l'étape d) lors de la sélection.

5. Dispositif de simulation selon la revendication 1 ou 2, **caractérisé en ce que** les données de performance enregistrées (L) sont enregistrées pour différents points de fonctionnement (P) et/ou états de fonctionnement de la/des turbomachine/s (V1, ..., Vn).

6. Dispositif de simulation selon l'une quelconque des revendications précédentes, **caractérisé en ce que** la sélection dans l'étape d) de la revendication 1 concernant au moins la consommation d'énergie, un comportement sonore ou une autre grandeur dépendant des points de fonctionnement (P) de la ou des turbomachine/s (V1, ..., Vn) a lieu.

7. Dispositif de simulation selon l'une quelconque des revendications précédentes, **caractérisé en ce que** le dispositif de simulation présente un champ de données pour l'enregistrement ou la saisie d'une valeur de consigne (S) d'une grandeur et cette valeur de consigne (S) est utilisée en tant que valeur limite supérieure ou inférieure lors de la détermination de la valeur de sélection (SW).

8. Dispositif de simulation selon l'une quelconque des revendications précédentes, **caractérisé en ce qu'**un opérateur de détermination d'énergie (50) est prévu en outre, lequel détermine lors d'une saisie de paramètres liés au fonctionnement (Pb) une valeur d'énergie ou une valeur équivalente à une consommation d'énergie prévue à partir des données de performance (L) et des paramètres liés au fonctionnement (Pb) pour les turbomachines (V1, ..., Vn) sélectionnées et l'affiche sur le dispositif d'affichage (10).

9. Dispositif de simulation selon au moins une des revendications précédentes, **caractérisé en ce qu'**une unité de génération d'image est prévue, laquelle représente les paramètres liés au fonctionnement (Pb) saisis et/ou paramètres liés à la turbomachine (Pm) en tant que vues graphiques et/ou symboles, en particulier de différente taille, en particulier en tant que cercles de différents diamètres sur l'unité d'affichage (10).

10. Dispositif de simulation selon l'une quelconque des revendications précédentes, **caractérisé en ce qu'**au moins les lignes caractéristiques de ventilateur ou le champ de lignes caractéristiques de ventilateur est utilisé en tant que données de performance (L) spécifiques à la turbomachine, et peut être représenté de préférence sur l'unité d'affichage (10).

11. Dispositif de simulation selon l'une quelconque des revendications précédentes, **caractérisé en ce que** le dispositif de simulation présente un logiciel de commande pour régler ou adapter l'état de fonctionnement des ou du groupe sélectionné de n turbomachines (V1, ..., Vn).

12. Dispositif de simulation selon la revendication 11, **caractérisé en ce que** le logiciel de commande est réalisé pour régler, obtenir ou adapter un état de fonctionnement souhaité des ou du groupe sélectionné de n turbomachines (V1, ..., Vn) en tenant compte d'états de dérangement d'une ou plusieurs des turbomachines (V1, ..., Vn).

13. Dispositif de simulation selon la revendication 11 ou 12, **caractérisé en ce que** le logiciel de commande est réalisé pour compenser un reflux dans n' turbomachines (V1, ..., Vn) non actives ou dérangées par activation d'une augmentation de performance des n-n' autres turbomachines (V1, ..., Vn).

14. Dispositif de simulation selon la revendication 13, **caractérisé en ce que** les données de débit dans les n' turbomachines avec un reflux sont mesurées au moyen d'une unité de détection pour les transmettre au logiciel de commande pour l'adaptation ou le réglage de l'état de fonctionnement.

15. Dispositif de simulation selon l'une quelconque des revendications précédentes, **caractérisé en ce que** le dispositif de simulation génère lors de la sélection d'une turbomachine ou d'un groupe de n turbomachines (V1, ..., Vn), une information de mise en service et/ou information de commande pour la mise en service et/ou le fonctionnement de la turbomachine ou du groupe de n turbomachines (V1, ..., Vn) et la met à disposition de préférence par le biais d'une interface de données filaire ou sans fil.

16. Dispositif de simulation selon l'une quelconque des revendications précédentes, **caractérisé en ce que** l'installation est émise en tant que visualisation sur un écran ou un dispositif de sortie et lors de la modification des paramètres à réglage variable, lesquels représentent des états de système à changement dynamique sur une période de temps T d'une installation, les turbomachines (V1, ..., Vn) respectivement sélectionnées sont représentées dans l'installation simulée.
